# FASCICULE DE BREVET EUROPEEN

(11) **EP 3 196 665 B1**
(45) Date de publication et mention de la délivrance du brevet: **06.09.2023**
(21) Numéro de dépôt: 17151070.4
(22) Date de dépôt: 11.01.2017
(51) Int. Cl.: G01R 33/30, G01R 33/31

(54) **SYSTÈME DE CANALISATION DE FLUIDE D'UN SYSTÈME RMN ET PROCÉDÉ DE FONCTIONNEMENT D'UN TEL SYSTÈME**
FLÜSSIGKEITSKANALISIERUNGSSYSTEM EINES NMR-SYSTEMS, UND VERFAHREN ZUM BETREIBEN EINES SOLCHEN SYSTEMS
FLUID PIPING SYSTEM FOR AN NMR SYSTEM AND METHOD FOR OPERATING SUCH A SYSTEM

(30) Priorité: 12.01.2016 FR 1650224
(43) Date de publication de la demande: 26.07.2017
(73) Titulaire: COMMISSARIAT À L'ÉNERGIE ATOMIQUE ET AUX ÉNERGIES ALTERNATIVES, 75015 Paris (FR)
(72) Inventeur: BOULEAU, Eric, 38360 SASSENAGE (FR); LEE, Daniel, 38100 GRENOBLE (FR)
(74) Mandataire: Novaimo

(56) Documents cités:
- WO-A2-2014/102349
- US-A1- 2006 097 146
- US-A1- 2007 261 416
- US-A1- 2016 223 628
- WENDELL H. POTTER: "Apparatus to Rotate Samples Rapidly at Temperatures Less than 2 K in High Transverse Magnetic Fields", REVIEW OF SCIENTIFIC INSTRUMENTS., vol. 42, no. 5, 1 mai 1971 (1971-05-01), - 31 mai 1971 (1971-05-31), page 618, XP055295061, US ISSN: 0034-6748, DOI: 10.1063/1.1685187
- MATSUKI YOH ET AL: "Closed-cycle cold helium magic-angle spinning for sensitivity-enhanced multi-dimensional solid-state NMR", JOURNAL OF MAGNETIC RESONANCE, vol. 259, 12 août 2015 (2015-08-12), pages 76-81, XP029286614, ISSN: 1090-7807, DOI: 10.1016/J.JMR.2015.08.003
- MARIA CONCISTRÈ ET AL: "Magic-Angle Spinning NMR of Cold Samples", ACCOUNTS OF CHEMICAL RESEARCH., vol. 46, no. 9, 17 septembre 2013 (2013-09-17), pages 1914-1922, XP055297994, US ISSN: 0001-4842, DOI: 10.1021/ar300323c

## Description

L'invention concerne un système de canalisation de fluide d'un système RMN. L'invention concerne aussi un système RMN comprenant un tel système de canalisation. L'invention concerne encore un procédé de fonctionnement de tels systèmes.

Concernant l'état de la technique antérieure, WO 2014/102349 A2 divulgue un système de canalisation de fluide pour un système RMN de rotation à l'angle magique. Par ailleurs, US 2006/097146 A1 divulgue un système de canalisation de fluide pour un spectromètre à RMN.

Un dispositif RMN (ou dispositif de détection ou d'analyse à Résonance Magnétique Nucléaire) comprend un porte-échantillon mis en rotation dans un champ magnétique statique et exposé à un second champ magnétique perpendiculaire au premier et créé par une bobine radiofréquence qui reçoit en retour un signal qui est analysé pour en déduire des informations sur un échantillon solide disposé dans le porte-échantillon. Selon une réalisation de l'état de la technique, plusieurs flux gazeux provenant d'une même source, un container standard comme une bouteille d'hélium montée en pression, sont dirigés vers la sonde du dispositif qui comprend le porte-échantillon. Un premier flux a pour fonction de mettre en rotation le porte-échantillon, en agissant sur les pales ou ailettes d'une turbine d'entraînement d'un rotor qui comprend le porte-échantillon. Un second flux a pour fonction de porter l'échantillon à une certaine température. Un troisième flux crée un palier aérostatique de sustentation du rotor dans le stator. Éventuellement, un quatrième flux permet de refroidir un écran thermique protégeant le dispositif d'un rayonnement thermique.

Les flux sont assurés et canalisés par un système de canalisation. Le système de canalisation et le dispositif RMN forment un système RMN.

La recherche de la meilleure performance d'analyse d'un échantillon à l'état solide par RMN utilise une mise en rotation de l'échantillon selon un axe particulier appelé « l'angle magique ». Il est important d'atteindre une vitesse de rotation élevée. D'autre part, l'augmentation de l'intensité des champs magnétiques, qui atteint actuellement environ 20 Tesla, a amélioré la sensibilité de la détection RMN. Il est toutefois très difficile aujourd'hui d'augmenter cette intensité.

Les solutions existantes restent imparfaites et insuffisantes et il existe donc un besoin général d'amélioration de la détection et de l'analyse par RMN d'un échantillon solide.

Depuis quelques années, laboratoires de recherche et industriels travaillent au développement de prototypes afin d'atteindre plusieurs dizaine de kilohertz de fréquence de rotation de l'échantillon et cela dans la gamme de température 10K-100K.

Plus précisément, l'échantillon à étudier ou à qualifier par cette technique est placé dans un tube qui a la fonction de rotor. Ce tube équipé d'un bouchon à une extrémité si l'autre est borgne ou de deux bouchons forme le porte-échantillon ou rotor et est installé dans un stator. Les bouchons sont usinés de telle sorte qu'ils forment des turbines (donc une ou deux turbines) par rotor. Les turbines sont alimentées par les flux de gaz distribués par le stator. Le rotor est ainsi mis en rotation. L'ensemble rotor-stator constituant une machine tournante est pourvu de paliers gazeux dont la configuration peut-être du type aérodynamique, aérostatique ou hybride. Les paliers sont également alimentés par les flux gazeux via le stator. Un autre flux gazeux permet de porter l'échantillon à la température souhaitée pour en réaliser l'étude. Un tel système est de petite taille puisque le diamètre du rotor porte-échantillon peut être par exemple compris entre 0,7 mm et 7 mm. Ceci implique une forte compacité de l'ensemble stator-rotor.

Les différents flux gazeux peuvent être distribués radialement ou tangentiellement sur le rotor. Ils peuvent être évacués axialement, du centre vers l'extérieur du stator. Les flux gazeux alimentant la ou les turbines sont évacués les plus facilement puisque la ou les turbines sont situées aux extrémités du rotor. Les flux gazeux alimentant les paliers arrivent sur le rotor à proximité des turbines. Le flux gazeux refroidissant l'échantillon arrive sur le rotor dans sa zone centrale.

Cet agencement fluidique est tel que le flux refroidissant l'échantillon balaye, quand il est évacué axialement, les zones des paliers, puis les zones des turbines. Les flux alimentant les paliers balayent quant à eux, quand ils sont évacués axialement, les zones des turbines. Les flux alimentant les paliers créent des coins fluides dans les zones des paliers. Il s'ensuit une relative étanchéité telle que les flux alimentant les turbines situées aux extrémités du rotor ne peuvent s'évacuer vers la zone centrale du rotor. Ainsi, les flux alimentant les turbines ne peuvent pas influencer la température de la zone centrale du rotor où se trouve l'échantillon. Les flux alimentant les paliers sont dirigés et évacués dans l'axe du rotor vers ses extrémités poussés par le flux refroidissant la zone centrale du rotor et l'échantillon.

Les matériaux utilisés pour la fabrication du tube et des turbines (céramiques et plastiques) sont de mauvais conducteurs thermiques. Il s'ensuit que le flux thermique (par conduction solidienne) des extrémités du rotor vers la zone centrale du rotor est négligeable. Une zone de contact aux interfaces du tube et des turbines crée de plus une résistance thermique de contact qui limite encore d'autant le flux thermique.

En conséquence, les températures des flux alimentant les paliers et les turbines peuvent être supérieures à celle du flux refroidissant l'échantillon.

Pour fonctionner à très basse température, il convient de fournir des gaz froids.

Dans la gamme de température 90K à 300K, l'azote apparaît comme le fluide à utiliser à l'évidence dès lors qu'il est non dangereux, peu coûteux et simple d'utilisation.

A plus basse température et jusqu'au environ de 10K, l'hélium s'impose comme l'élément à utiliser de par ses caractéristiques thermo-physiques. Au-dessus de 90K, mis à part les aspects thermiques, c'est également le cas puisque l'hélium permet d'obtenir des fréquences de rotation deux fois supérieures à celle générées avec de l'azote. Cependant, quoiqu'indispensable pour faire de la RMN entre 10K et 90K, l'hélium génère des coûts de fonctionnement rapidement prohibitifs. Ainsi, très peu de laboratoires dans le monde peuvent réaliser des analyses RMN, même expérimentalement, en dessous de 100K.

Deux solutions sont actuellement appliquées pour pallier cette difficulté.

Comme théoriquement il est seulement nécessaire de refroidir l'échantillon, en négligeant des pertes thermiques, seul le flux de refroidissement de l'échantillon requiert du fluide réfrigéré. Ainsi, un prototype développé il y a plusieurs années utilise l'azote comme fluide pour alimenter les paliers et les turbines et l'hélium comme fluide de refroidissement de l'échantillon. Cette technique nécessite un rotor allongé pour réduire l'influence thermique de l'azote à 90K, utilisé aux extrémités du rotor (dans les zones des paliers et des turbines, sur la zone centrale). Cette zone centrale est alimentée par un flux d'hélium entre 10K et 90K. Quoiqu'astucieuse, cette solution est technologiquement complexe à mettre en oeuvre et n'est pas durable pour l'obtention de spectres RMN de longues durées.

Une autre solution consiste à récupérer le gaz à l'échappement du stator et à le remettre en circulation dans le dispositif par une boucle fermée pressurisée. Dans cette boucle, le gaz est descendu à la température de fonctionnement souhaitée par une source cryogénique via un ou des échangeurs thermiques. L'ensemble travaille suivant un cycle de Brayton. Compte tenu de la forte compacité de ce système pneumatique miniature mais surtout du fonctionnement en boucle fermée, la seule solution semble résider dans l'utilisation de flux qui sont tous à la même température. Le gaz récupéré à l'échappement du stator commun aux différents flux est injecté dans un échangeur thermique à contre-courant afin d'échanger de la chaleur avec les différents flux alimentant l'ensemble stator-rotor pour pré-refroidir ces flux. Si les températures des flux alimentant les paliers et/ou les turbines étaient supérieures à la température du flux refroidissant l'échantillon, la température du gaz d'échappement serait trop haute et déséquilibrerait le cycle thermique qui ne serait plus viable.

Le fonctionnement avec des températures de flux identiques n'est pas très problématique jusque vers 50K. En dessous, le fonctionnement devient plus complexe pour différentes raisons.

En dessous de 30K, les caractéristiques thermophysiques de l'hélium varient très fortement et non linéairement et la maîtrise de la rotation devient délicate et sensible pour assurer une fréquence de rotation constante.

Au niveau des paliers, la forte variation de la densité de l'hélium entraîne une contraction importante du volume gazeux du palier. Ainsi, le débit doit être ajusté en conséquence et rapidement pour assurer une raideur adaptée et constante du palier afin de préserver une rotation sans excentration perturbatrice de la fréquence, voire destructrice du rotor.

Au niveau des turbines, la puissance mécanique reçue sur les pâles est fonction du rapport de la valeur de débit massique élevée au cube sur la valeur de densité du gaz élevée au carré. Le gaz utilisé pour passer d'une rotation à température ambiante, c'est-à-dire 300K, à une rotation à 10K est nécessairement de l'hélium. Or la densité de l'hélium est sensiblement multipliée par 30 entre 300K et 10K. Le débit massique doit donc être multiplié par 10 sur le même intervalle de températures pour obtenir une puissance constante.

Ainsi, le débit à appliquer pour entretenir la rotation à une température T comprise entre 300K et 8K relativement au débit initial établi à la température ambiante, est quasi exponentiel et dépendant de la loi suivante :
m°=50,5×T^{-0,68} avec m° le débit massique et T la température du flux.

Entre 300K et 50K, le débit est augmenté d'un facteur 3 pour conserver une fréquence de rotation constante alors que, de 50K à 25K, ce facteur est quasiment de 2. Globalement, pour un fonctionnement constant à 30kHZ jusqu'à 10K le débit massique doit être théoriquement multiplié par 10. Par exemple, un rotor de sonde RMN de 2 mm de diamètre va nécessiter un débit compris entre 0,1 et 0,2 g.s⁻¹ pour tourner à 30kHz à la température ambiante. Ce débit devra être de 1 à 2 g.s⁻¹ pour fonctionner à 10K.

En conséquence, le dispositif de recirculation et la source cryogénique (constitué d'un échangeur et d'un cryoréfrigérateur) doivent être très adaptables mais surtout surdimensionnés à haute température pour traiter ces très fortes variations de débits et assurer un fonctionnement correct à très basse température.

Un dernier problème est dû à l'accouplement entre le tube et les turbines. Pour des raisons de fiabilité mécanique mais également économique, le tube et les turbines sont fabriqués dans des matériaux différents. Le tube qui doit offrir la plus faible susceptibilité magnétique possible est par exemple en zirconia (dioxyde de zirconium), matériau obtenu par frittage et sensible aux chocs, raison pour laquelle les turbines dans lesquelles les ailettes sont pratiquées, sont réalisées par exemple en un polymère à base de polyimide comme du Vespel^{®} (marque déposée par DuPont). Ces deux matériaux offrent de bonnes caractéristiques pour travailler dans le domaine cryogénique mais ont des contractions différentielles d'autant plus éloignées que la température est basse. La turbine montée serrée à température ambiante dans le tube l'est de moins en moins lorsque la température décroît. La perte d'une turbine peut alors survenir aléatoirement en fonction des brusques changements de régimes de débits comme explicité précédemment.

Il apparaît donc que, pour des raisons dynamiques et mécaniques, il est souhaitable de mettre en oeuvre des flux alimentant les paliers et les turbines à des températures moins basses que celle du flux refroidissant l'échantillon. Toutefois, en adoptant cette solution, les dispositifs connus de l'art antérieur ne peuvent fonctionner correctement.

Le but de l'invention est de remédier aux inconvénients cités précédemment et d'améliorer les systèmes RMN connus de l'art antérieur. En particulier, l'invention propose un système de canalisations simple et qui permette de réaliser une gestion efficace du fluide frigorifique.

Selon l'invention, le système de canalisation de fluide pour système RMN comprend un circuit d'échappement du système RMN comprenant une première branche de circulation de fluide et une deuxième branche de circulation de fluide.

De préférence, dans ce circuit d'échappement, les première et deuxième branches conduisent de manière simultanée le fluide frigorifique du dispositif RMN au compresseur. Ainsi, un débit non nul de fluide frigorifique circule simultanément dans les première et deuxième branches lorsque le dispositif RMN fonctionne.

La configuration du circuit d'échappement comprenant ces première et deuxième branches participe à constituer un système de canalisation simple tout en améliorant l'efficacité de la gestion du fluide frigorifique dans ce système et ce, en contribuant à la mise en oeuvre d'un flux ayant pour fonction de refroidir un échantillon du dispositif RMN à une température adéquate, ce flux étant séparé d'autres flux assurant différentes autres fonctions dans le système de canalisation à des températures plus élevées comme notamment l'alimentation de paliers et de turbines du dispositif RMN. Une telle configuration offre ainsi une importante souplesse de fonctionnement du système RMN.

La première branche peut ne pas comprendre de conduite de cryoréfrigérateur et/ou la deuxième branche peut comprendre une conduite d'un premier cryoréfrigérateur.

La première branche comprend une conduite d'un premier échangeur thermique et la deuxième branche comprend une conduite d'un deuxième échangeur thermique et une conduite d'un troisième échangeur thermique.

Le système comprend un circuit d'alimentation du système RMN comprenant une troisième branche de circulation de fluide et une quatrième branche de circulation de fluide.

La troisième branche de circulation de fluide comprend plusieurs sous-branches, dont une première sous-branche de circulation d'un premier flux qui a pour fonction de mettre en rotation un porte-échantillon en agissant sur des pales ou ailettes d'une turbine d'entraînement d'un rotor du dispositif RMN, le rotor comprenant le porte-échantillon, et une deuxième sous-branche de circulation d'un troisième flux qui a pour fonction de créer un palier de sustentation du rotor dans un stator du dispositif RMN et une troisième sous-branche de circulation d'un quatrième flux qui a pour fonction de refroidir un écran thermique protégeant le dispositif RMN de rayonnements thermiques.

La troisième branche peut comprendre au moins une conduite d'un deuxième cryoréfrigérateur et/ou la quatrième branche peut comprendre une conduite d'un troisième cryoréfrigérateur et une conduite d'un quatrième cryoréfrigérateur.

Le deuxième cryoréfrigérateur et le troisième cryoréfrigérateur peuvent être un même cryoréfrigérateur, notamment un même étage d'un cryoréfrigérateur.

Le premier cryoréfrigérateur et le quatrième cryoréfrigérateur peuvent être un même cryoréfrigérateur, notamment un même étage d'un cryoréfrigérateur.

Le système peut comprendre un seul cryoréfrigérateur, notamment un cryoréfrigérateur comprenant un premier étage et un deuxième étage. Autrement dit, ce seul cryoréfrigérateur du système RMN comprend deux étages remplissant chacun les fonctions de deux cryoréfrigérateurs telles que celles des premier et quatrième cryoréfrigérateurs, et des deuxième et troisième cryoréfrigérateurs.

La troisième branche comprend au moins une conduite du premier échangeur thermique et la quatrième branche comprend une conduite du troisième échangeur thermique et une conduite du deuxième échangeur thermique.

La deuxième branche peut comprendre un régulateur de débit.

La troisième branche peut comprendre au moins un régulateur de débit et/ou la quatrième branche peut comprendre un régulateur de débit.

Un système RMN selon l'invention comprend un système de canalisation tel que défini précédemment et un dispositif RMN de rotation à l'angle magique.

Selon un premier aspect, un procédé de fonctionnement d'un système tel que défini précédemment, est caractérisé en ce que les première et deuxième branches conduisent de manière simultanée le fluide frigorifique, notamment entre un dispositif RMN de rotation à l'angle magique du système RMN et un compresseur du système RMN.

De préférence, on régule les débits de sorte que les débits de fluide dans les première et troisième branches soient égaux ou sensiblement égaux et/ou on régule les débits de fluide de sorte que les débits dans les deuxième et quatrième branches soient égaux ou sensiblement égaux. Selon un deuxième aspect, un procédé de fonctionnement d'un système tel que défini précédemment, est caractérisé en ce qu'on régule les débits de sorte que les débits de fluide dans les première et troisième branches soient égaux ou sensiblement égaux et/ou en ce qu'on régule les débits de fluide de sorte que les débits dans les deuxième et quatrième branches soient égaux ou sensiblement égaux.

Les objets, caractéristiques et avantages de la présente invention sont exposés en détail dans la description suivante de deux modes de réalisation particuliers en référence au dessin annexé. Ces modes de réalisation sont non limitatifs. Le dessin annexé est composé comme suit :
La figure 1 représente schématiquement un premier mode de réalisation d'un système RMN selon l'invention.
La figure 2 représente schématiquement un deuxième mode de réalisation d'un système RMN selon l'invention.

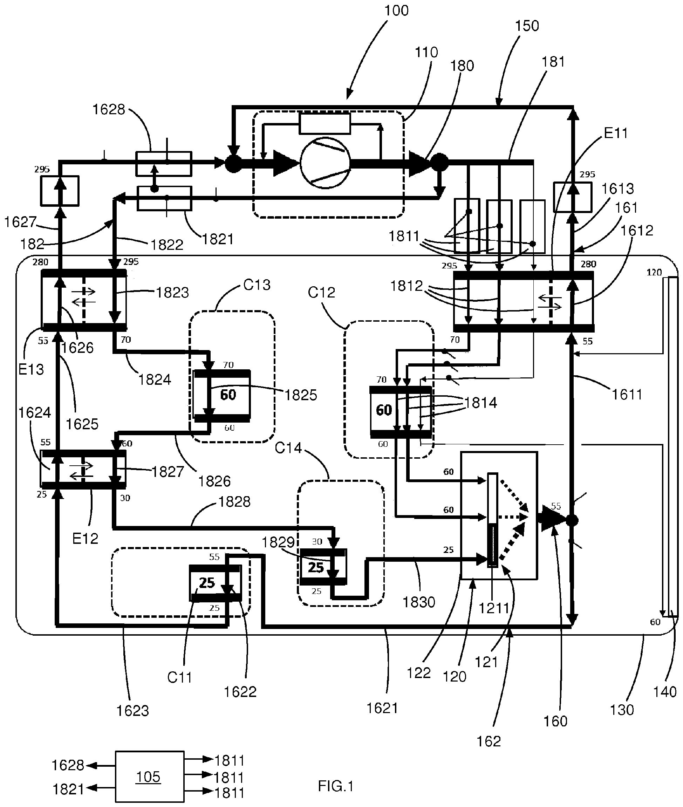

Un premier mode de réalisation d'un système RMN 100 selon l'invention est décrit ci-après en référence à la figure 1.

Le système RMN 100 comprend principalement un compresseur 110, un dispositif RMN 120, une enceinte calorifugée 130 et un premier mode de réalisation d'un système de canalisation 150. Le dispositif RMN 120 comprend un rotor ou un porte-échantillon 121 comprenant une turbine 1211. Le dispositif RMN 120 est agencé, en particulier le rotor est guidé, de sorte que l'échantillon puisse être mis en rotation selon un axe particulier appelé « angle magique ».

De préférence, l'enceinte calorifugée 130 comprend un écran thermique 140. L'enceinte renferme de préférence le dispositif RMN 120 et une partie du système de canalisation 150.

Le système de canalisation 150 comprend principalement un circuit d'échappement 160 permettant de conduire un fluide frigorifique du dispositif RMN 120 au compresseur 110 et un circuit d'alimentation 180 permettant de conduire le fluide frigorifique du compresseur 110 au dispositif RMN 120.

Le circuit d'échappement 160 comprend une première branche d'échappement 161 et une deuxième branche d'échappement 162. De préférence, le circuit d'échappement 160 se divise en les première et deuxième branches d'échappement 161, 162 juste après le dispositif RMN 120. De préférence encore, les deux branches d'échappement 161, 162 se rejoignent juste avant le compresseur. Ainsi, les première et deuxième branches 161, 162 sont de préférence des branches parallèles.

La première branche d'échappement 161 comprend principalement une conduite 1612 d'un premier échangeur E11. La première branche d'échappement 161 comprend évidemment également des conduites 1611 et 1613 complétant la conduite 1612 de sorte à guider une partie du fluide frigorifique s'échappant du dispositif RMN 120 vers le compresseur 110. Ainsi, une première partie du fluide frigorifique s'échappant du dispositif RMN 120 retourne au compresseur 110 en traversant le premier échangeur E11.

La deuxième branche d'échappement 162 comprend principalement une conduite 1622 d'un premier cryoréfrigérateur C11, une conduite 1624 d'un deuxième échangeur E12 et une conduite 1626 d'un troisième échangeur E13. La deuxième branche d'échappement 162 comprend évidemment également des conduites 1621, 1623, 1625, 1627 complétant les conduites 1622, 1624, 1626 de sorte à guider une partie du fluide frigorifique s'échappant du dispositif RMN 120 vers le compresseur 110. Ainsi, une deuxième partie du fluide frigorifique s'échappant du dispositif RMN 120 retourne au compresseur 110 en traversant le premier cryoréfrigérateur C11, le deuxième échangeur E12 et le troisième échangeur E13. Avantageusement, il traverse ces éléments dans cet ordre.

Dans cette configuration, les première et deuxième branches d'échappement 161, 162 conduisent de manière simultanée le fluide frigorifique provenant du dispositif RMN 120 vers le compresseur 110. En effet, de préférence, ces première et deuxième branches d'échappement 161, 162 relient une sortie de fluide du dispositif RMN 120 à une entrée de fluide du compresseur 110 en étant dépourvues, notamment au niveau d'au moins une de leurs conduites 1611 à 1613 et 1621 à 1626, d'au moins un élément de redirection et/ou d'autorisation/interdiction de passage d'un tel fluide frigorifique, comme une vanne. On notera qu'un régulateur de débit 1628 décrit par la suite ne constitue pas un élément de redirection et/ou d'autorisation/interdiction de passage.

Le circuit d'alimentation comprend une troisième branche d'alimentation 181 et une quatrième branche d'alimentation 182. De préférence, le circuit d'alimentation se divise en les troisième et quatrième branches d'alimentation 181, 182 juste après le compresseur 110. De préférence encore, les deux branches d'alimentation 181, 182 demeurent séparées jusque dans le dispositif RMN 120. Ainsi, les troisième et quatrième branches 181, 182 sont de préférence des branches parallèles.

La troisième branche d'alimentation 181 comprend principalement une ou plusieurs conduites 1812 dans le premier échangeur E11 et une ou plusieurs conduites 1814 dans un deuxième cryoréfrigérateur C12. La troisième branche d'alimentation comprend évidemment également des conduites complétant les conduites 1812 et 1814 de sorte à guider une partie du fluide frigorifique du compresseur au dispositif RMN 120. Ainsi, une première partie du fluide frigorifique circule du compresseur au dispositif RMN 120 en traversant le premier échangeur E11 et le deuxième cryoréfrigérateur C12. De préférence, le fluide traverse les différents éléments dans cet ordre.

La quatrième branche d'alimentation 182 comprend principalement une conduite 1823 du troisième échangeur E13, une conduite 1825 d'un troisième cryoréfrigérateur C13, une conduite 1827 du deuxième échangeur E12 et une conduite 1829 d'un quatrième cryoréfrigérateur C14. La quatrième branche d'alimentation 182 comprend évidemment également des conduites 1822, 1824, 1826, 1828 et 1830 complétant les conduites 1823, 1825, 1827 et 1829 de sorte à guider une partie du fluide frigorifique du compresseur 110 au dispositif RMN 120. Ainsi, une deuxième partie du fluide frigorifique circule du compresseur 110 au dispositif RMN 120 en traversant le troisième échangeur E13, le troisième cryoréfrigérateur C13, le deuxième échangeur E12 et le quatrième cryoréfrigérateur C14. De préférence, le fluide traverse les différents éléments dans cet ordre.

La première partie de fluide transitant dans le circuit d'alimentation est constituée par :
- un premier flux qui a pour fonction de mettre en rotation le porte-échantillon 121, en agissant sur des pales ou ailettes de la turbine d'entraînement 1211 du rotor du dispositif RMN 120, le rotor comprenant le porte-échantillon 121 ; et
- un troisième flux qui crée un palier aérostatique de sustentation du rotor dans un stator 122 du dispositif RMN 120, et, éventuellement,
- un quatrième flux permet de refroidir l'écran thermique 140 protégeant le dispositif RMN 120 des rayonnements thermiques.

Ainsi, la troisième branche de circulation 181 comprend trois sous-branches :
- une première sous-branche de circulation du premier flux qui a pour fonction de mettre en rotation le porte-échantillon 121, en agissant sur les pales ou ailettes de la turbine d'entraînement du rotor du dispositif RMN 120, le rotor comprenant le porte-échantillon 121 ;
- une deuxième sous-branche de circulation du troisième flux qui a pour fonction de créer le palier aérostatique de sustentation du rotor dans le stator 122 du dispositif RMN 120 ;
- une troisième sous-branche de circulation du quatrième flux qui a pour fonction de refroidir l'écran thermique 140 protégeant le dispositif RMN 120 de rayonnements thermiques.

Le premier échangeur E11 et le deuxième cryoréfrigérateur C12 présentent ainsi, au niveau de la troisième branche 181 autant de conduites que de sous-branches.

La deuxième partie de fluide transitant dans le circuit d'alimentation est constituée par un second flux qui a pour fonction de porter l'échantillon à une température adéquate. Ainsi, la quatrième branche 182 qui conduit cette deuxième partie du fluide conduit également l'unique flux de cette deuxième portion de fluide ici le second flux dont la seule fonction est de porter l'échantillon à cette température adéquate.

La deuxième branche 162 comprend un régulateur de débit 1628.

La troisième branche 181 comprend trois régulateurs de débit 1811. Ils permettent de régler et/ou réguler les débits circulant dans les trois sous-branches.

La quatrième branche 182 comprend un régulateur de débit 1821.

Ces régulateurs 1628, 1811, 1821 sont de préférence du type débitmètre-régulateur, c'est-à-dire qu'ils permettent également de mesurer les débits.

Le système de canalisation 150 comprend également un module de commande 105 comme un microcontrôleur permettant de recevoir des informations de débits et de calculer en conséquence des ordres de commandes qui sont transmis aux régulateurs 1628, 1811, 1821. Ces ordres déterminent des configurations des différents régulateurs 1628, 1811, 1821.

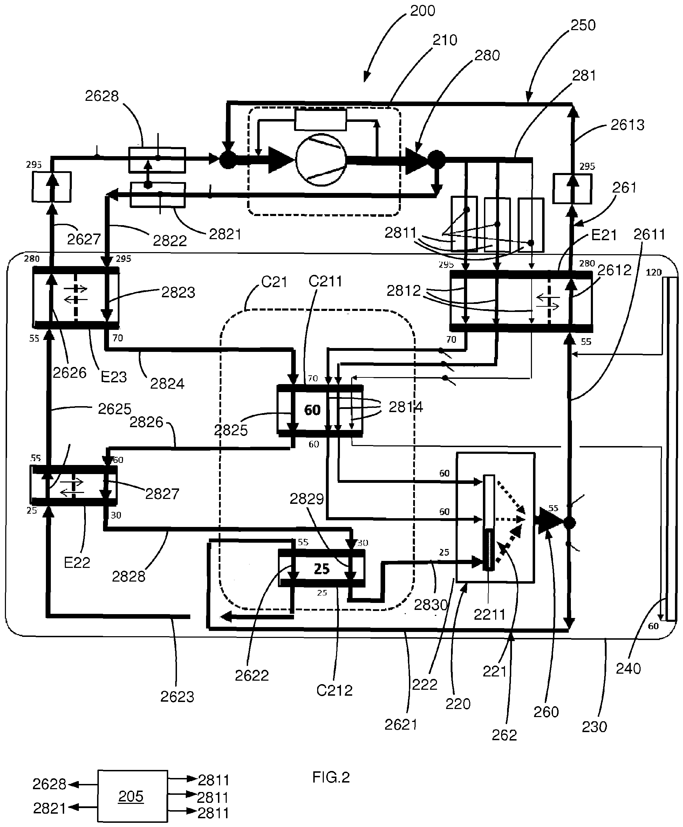

Un deuxième mode de réalisation d'un système RMN 200 selon l'invention est décrit ci-après en référence à la figure 2.

Le système RMN 200 comprend principalement un compresseur 210, un dispositif RMN 220, une enceinte calorifugée 230 et un premier mode de réalisation d'un système de canalisations 250. Le dispositif RMN 220 comprend un rotor ou un porte-échantillon 121 comprenant une turbine 2211. Le dispositif RMN 220 est agencé, en particulier le rotor est guidé, de sorte que l'échantillon puisse être mis en rotation selon un axe particulier appelé « angle magique ».

De préférence, l'enceinte calorifugée 230 comprend un écran thermique 240. L'enceinte 230 renferme de préférence le dispositif RMN 220 et une partie du système de canalisation 250.

Le système de canalisation 250 comprend principalement un circuit d'échappement 260 permettant de conduire un fluide frigorifique du dispositif RMN 220 au compresseur 210 et un circuit d'alimentation 280 permettant de conduire le fluide frigorifique du compresseur 210 au dispositif RMN 220.

Le circuit d'échappement 260 comprend une première branche d'échappement 261 et une deuxième branche d'échappement 262. De préférence, le circuit d'échappement 260 se divise en les première et deuxième branches d'échappement 261, 262 juste après le dispositif RMN 220. De préférence encore, les deux branches d'échappement 261, 262 se rejoignent juste avant le compresseur 210. Ainsi, les première et deuxième branches 261, 262 sont de préférence des branches parallèles.

La première branche d'échappement 261 comprend principalement une conduite 2612 d'un premier échangeur E21. La première branche d'échappement 261 comprend évidemment également des conduites 2611 et 2613 complétant la conduite 2612 de sorte à guider une partie du fluide frigorifique s'échappant du dispositif RMN 220 vers le compresseur 210. Ainsi, une première partie du fluide frigorifique s'échappant du dispositif RMN 220 retourne au compresseur 210 en traversant le premier échangeur E21.

La deuxième branche d'échappement 262 comprend principalement une conduite 2622 d'un étage C212 d'un cryoréfrigérateur C21, une conduite 2624 d'un deuxième échangeur E22 et une conduite 2626 d'un troisième échangeur E23. On notera que cet étage C212 du cryoréfrigérateur C21 peut également être identifié comme premier ou quatrième cryoréfrigérateurs par analogie aux premier et quatrième cryoréfrigérateurs C11, C14 du système de canalisation 150 du premier mode de réalisation du système RMN 100. En effet, cet étage C212 présente sensiblement les mêmes caractéristiques que ces cryoréfrigérateurs C11, C14 et remplit notablement dans le système 250 des fonctions similaires à celles de ces derniers.

La deuxième branche d'échappement 262 comprend évidemment également des conduites 2621, 2623, 2625, 2627 complétant les conduites 2622, 2624, 2626 de sorte à guider une partie du fluide frigorifique s'échappant du dispositif RMN 220 vers le compresseur 210. Ainsi, une deuxième partie du fluide frigorifique s'échappant du dispositif RMN 220 retourne au compresseur 210 en traversant l'étage C212 du cryoréfrigérateur C21, le deuxième échangeur E22 et le troisième échangeur E23. Avantageusement, il traverse ces éléments dans cet ordre.

Dans cette configuration, les première et deuxième branches d'échappement 261, 262 conduisent de manière simultanée le fluide frigorifique provenant du dispositif RMN 220 vers le compresseur 210. En effet, de préférence, ces première et deuxième branches d'échappement 261, 262 relient une sortie de fluide du dispositif RMN 220 à une entrée de fluide du compresseur 210 en étant dépourvues notamment au niveau d'au moins une de leurs conduites 2611 à 1613 et 2621 à 2626, d'au moins un élément de redirection et/ou d'autorisation/interdiction de passage d'un tel fluide frigorifique, comme une vanne. On notera qu'un régulateur de débit 2628 décrit par la suite ne constitue pas un élément de redirection et/ou d'autorisation/interdiction de passage.

Le circuit d'alimentation comprend une troisième branche d'alimentation 281 et une quatrième branche d'alimentation 282. De préférence, le circuit d'alimentation se divise en les troisième et quatrième branches d'alimentation 281, 282 juste après le compresseur 210. De préférence encore, les deux branches d'alimentation 281,282 demeurent séparées jusque dans le dispositif RMN 220. Ainsi, les troisième et quatrième branches 281, 282 sont de préférence des branches parallèles.

La troisième branche d'alimentation 281 comprend principalement une ou plusieurs conduites 2812 dans le premier échangeur E21 et une ou plusieurs conduites 1814 dans un étage C211 du cryoréfrigérateur C21. On notera que cet étage C211 du cryoréfrigérateur C21 peut également être identifié comme deuxième ou troisième cryoréfrigénérateur par analogie au deuxième et troisième cryoréfrigérateurs C12 et C13 du système de canalisation 150 du premier mode de réalisation du système RMN 100. En effet, cet étage C211 présente sensiblement les mêmes caractéristiques que ces cryoréfrigérateurs C12 et C13 et remplit notablement dans ce système 250 des fonctions similaires à celles de ces derniers. La troisième branche d'alimentation 281 comprend évidemment également des conduites complétant les conduites 2812 et 2814 de sorte à guider une partie du fluide frigorifique du compresseur 210 au dispositif RMN 220. Ainsi, une première partie du fluide frigorifique circule du compresseur 210 au dispositif RMN 220 en traversant le premier échangeur E21 et l'étage C211 du cryoréfrigérateur C21. De préférence, le fluide traverse les différents éléments dans cet ordre.

La quatrième branche d'alimentation 282 comprend principalement une conduite 2823 du troisième échangeur E23, une conduite 2825 de l'étage C211 du cryoréfrigérateur C21, une conduite 2827 du deuxième échangeur E22 et une conduite 2829 de l'étage C212 du cryoréfrigérateur C21. La quatrième branche d'alimentation 282 comprend évidemment également des conduites 2822, 2824, 2826, 2828 et 2830 complétant les conduites 2823, 2825, 2827 et 2829 de sorte à guider une partie du fluide frigorifique du compresseur 210 au dispositif RMN 220. Ainsi, une deuxième partie du fluide frigorifique circule du compresseur 210 au dispositif RMN 220 en traversant le troisième échangeur E23, l'étage C211 du cryoréfrigérateur C21, le deuxième échangeur E22 et l'étage C212 du cryoréfrigérateur C21. De préférence, le fluide traverse les différents éléments dans cet ordre.

La première partie de fluide transitant dans le circuit d'alimentation est constituée par :
- un premier flux qui a pour fonction de mettre en rotation le porte-échantillon 221, en agissant sur des pales ou ailettes de la turbine d'entraînement 2211 du rotor du dispositif RMN 220, le rotor comprenant le porte-échantillon 221 ; et
- un troisième flux qui crée un palier aérostatique de sustentation du rotor dans un stator 222 du dispositif RMN 220, et, éventuellement,
- un quatrième flux permet de refroidir l'écran thermique 240 protégeant le dispositif RMN 220 des rayonnements thermiques.

Ainsi, la troisième branche de circulation 281 comprend trois sous-branches.
- une première sous-branche de circulation du premier flux qui a pour fonction de mettre en rotation le porte-échantillon 221, en agissant sur les pales ou ailettes de la turbine d'entraînement du rotor du dispositif RMN 220, le rotor comprenant le porte-échantillon 221 ;
- une deuxième sous-branche de circulation du troisième flux qui a pour fonction de créer le palier aérostatique de sustentation du rotor dans un stator 222 du dispositif RMN 220 ;
- une troisième sous-branche de circulation du quatrième flux qui a pour fonction de refroidir l'écran thermique 240 protégeant le dispositif RMN 220 de rayonnements thermiques.

Le premier échangeur E21 et le cryoréfrigérateur C21 notamment l'étage C211 de ce cryoréfrigérateur C21, présentent ainsi, au niveau de la troisième branche 281 autant de conduites que de sous-branches.

La deuxième partie de fluide transitant dans le circuit d'alimentation est constituée par un second flux qui a pour fonction de porter l'échantillon à une température adéquate. Ainsi, la quatrième branche 282 qui conduit cette deuxième partie du fluide conduit également l'unique flux de cette deuxième portion de fluide ici le second flux dont la seule fonction est de porter l'échantillon à cette température adéquate.

La deuxième branche 262 comprend un régulateur de débit 2628.

La troisième branche 281 comprend trois régulateurs de débit 2811. Ils permettent de régler et/ou réguler les débits circulant dans les trois sous-branches.

La quatrième branche 282 comprend un régulateur de débit 2821.

Ces régulateurs 2628, 2811, 2821 sont de préférence du type débitmètre-régulateur, c'est-à-dire qu'ils permettent également de mesurer les débits.

Le système de canalisation 250 comprend également un module de commande 205 comme un microcontrôleur permettant de recevoir des informations de débits et de calculer en conséquence des ordres de commandes qui sont transmis aux régulateurs 2628, 2811, 2821. Ces ordres déterminent des configurations des différents régulateurs 2628, 2811, 2821.

Dans les premier et deuxième modes de réalisation, les références des éléments identiques ou ayant la même fonction ne diffèrent que par leur premier chiffre : un « 1 » pour les éléments du premier mode et un « 2 » pour les éléments du deuxième mode.

Dans les différents modes de réalisation, les différents échangeurs E11 à E13 et E21 à E23 autrement appelés échangeurs thermiques ou échangeurs de chaleur, sont de préférence des échangeurs à contre-courant.

Dans les différents modes de réalisation, le fluide utilisé est par exemple de l'hélium. On comprend que ce fluide peut être un fluide de type gazeux ou liquide qui peut être notamment maintenu à une température cryogénique. Le fluide peut en outre subir des changements de phase. Ainsi, le fluide peut être gazeux dans une partie du système et liquide dans une autre partie du système.

Dans les différents modes de réalisation, le dispositif RMN 120, 220 comprend le rotor ou porte-échantillon 121, 221 et le stator 122, 222.

L'invention porte aussi sur un procédé de fonctionnement d'un système 100, 200, 150, 250 décrit précédemment.

Selon un premier aspect du procédé, les première et deuxième branches 161, 261, 162, 262 conduisent de manière simultanée le fluide frigorifique, notamment entre le dispositif RMN 120, 220 du système RMN 100, 200 et le compresseur 110, 210 du système RMN 100, 200.

De préférence, on régule les débits dans les différentes branches.

Avantageusement, la régulation des débits est telle que les débits de fluide dans les première et troisième branches 161, 261, 181, 281 sont égaux ou sensiblement égaux.

Avantageusement encore, la régulation des débits est telle que les débits dans les deuxième et quatrième branches 162, 262, 182, 282 sont égaux ou sensiblement égaux. En particulier, les régulateurs 1628 et 1821 ou 2628 et 2821 sont asservis pour respecter cette égalité.

Les débits évoqués plus haut sont des débits massiques.

Selon un deuxième aspect du procédé, on régule les débits de sorte que les débits de fluide dans les première et troisième branches 1161, 261, 181, 281 soient égaux ou sensiblement égaux et/ou en ce qu'on régule les débits de fluide de sorte que les débits dans les deuxième et quatrième branches 162, 262, 182, 282 soient égaux ou sensiblement égaux.

Sur les figures 1 et 2, différents nombres apparaissent outre les signes de référence. Il s'agit d'exemples de températures du fluide en différents points du système de canalisation 150, 250 où se trouve les nombres, c'est-à-dire en entrée et en sortie des échangeurs E11 à E13 et E21 à E23, des cryoréfrigérateurs C11 à C14 et C21 et du dispositif RMN 120, 220. Ces températures sont exprimées en kelvin.

Selon l'invention, le fait de séparer le flux qui a pour fonction de porter l'échantillon à une température adéquate des autres flux qui ont pour fonction de mettre en rotation le porte-échantillon 121, 221, de créer un palier aérostatique de sustentation du rotor dans un stator 122, 222 du dispositif RMN 120, 220, ou encore de refroidir l'écran thermique 140, 240 protégeant le dispositif RMN 120, 220 des rayonnements thermiques, offre une importante souplesse de fonctionnement du système RMN 100, 200.

## Revendications

1. Système de canalisation (150 ; 250) de fluide pour système RMN (100 ; 200), **caractérisé en ce que** le système de canalisation (150, 250) comprend :
- un circuit d'échappement (160 ; 260) du système RMN (100 ; 200) comprenant une première branche de circulation de fluide (161 ; 261) et une deuxième branche de circulation de fluide (162 ; 262), le circuit d'échappement permettant de conduire un fluide frigorifique d'un dispositif RMN de rotation à l'angle magique du système RMN (120) à un compresseur (110) du système RMN;
- un circuit d'alimentation (180; 280) du système RMN comprenant une troisième branche (181 ; 281) de circulation de fluide et une quatrième branche (182 ; 282) de circulation de fluide, le circuit d'alimentation permettant de conduire le fluide frigorifique du compresseur (110) au dispositif RMN (120) ;
- un premier échangeur thermique (E11, E21),
- un deuxième échangeur thermique (E12, E22),
- un troisième échangeur thermique (E13, E23) la première branche comprenant une conduite (1612 ; 2612) du premier échangeur thermique, la deuxième branche comprenant une conduite (2624 ; 2827) du deuxième échangeur thermique et une conduite (1626 ; 2626) du troisième échangeur thermique, la troisième branche comprenant une conduite (1812; 2812) du premier échangeur thermique et la quatrième branche comprenant une conduite (1827 ; 2827) du deuxième échangeur thermique et une conduite (1823 ; 2823) du troisième échangeur thermique,
la troisième branche (181 ; 281) comprenant plusieurs sous-branches, la troisième branche (181 ; 281) comprenant une première sous-branche de circulation d'un premier flux qui a pour fonction de mettre en rotation un porte-échantillon (121, 221), en agissant sur des pales ou ailettes d'une turbine d'entraînement d'un rotor du dispositif RMN (120, 220), le rotor comprenant le porte-échantillon (121, 221), et une deuxième sous-branche de circulation d'un troisième flux qui a pour fonction de créer un palier de sustentation du rotor dans un stator (122, 222) du dispositif RMN (120, 220) et une troisième sous-branche de circulation d'un quatrième flux qui a pour fonction de refroidir un écran thermique (140, 240) protégeant le dispositif RMN (120, 220) de rayonnements thermiques,
la quatrième branche (182 ; 282) conduisant un second flux dont la seule fonction est de porter un échantillon du dispositif RMN à une température adéquate.

2. Système (150 ; 250) selon la revendication précédente, **caractérisé en ce que** la première branche (161, 261) ne comprend pas de conduite de cryoréfrigérateur et/ou la deuxième branche (162, 262) comprend une conduite (1622 ; 2622) d'un premier cryoréfrigérateur (C11 ; C212).

3. Système (150 ; 250) selon l'une des revendication précédentes, **caractérisé en ce que** la troisième branche (181 ; 281) comprend au moins une conduite (1814 ; 2814) d'un deuxième cryoréfrigérateur (C12 ; C211) et/ou **en ce que** la quatrième branche (182, 282) comprend une conduite (1825 ; 2825) d'un troisième cryoréfrigérateur (C13 ; C211) et une conduite (1829; 2829) d'un quatrième cryoréfrigérateur (C14 ; C212).

4. Système (150 ; 250) selon l'une des revendications précédentes, **caractérisé en ce que** la deuxième branche (162, 262) comprend un régulateur de débit (1628 ; 2628).

5. Système (150 ; 250) selon l'une des revendications précédentes, **caractérisé en ce que** la troisième branche (181, 281) comprend au moins un régulateur de débit (1811 ; 2811) et/ou **en ce que** la quatrième branche (182, 282) comprend un régulateur de débit (1821 ; 2821).

6. Système RMN (100 ; 200) comprenant un système (150 ; 250) de canalisation selon l'une quelconque des revendications précédentes et un dispositif RMN de rotation à l'angle magique (120 ; 220).

7. Procédé de fonctionnement d'un système (100 ; 200 ; 150 ; 250) selon l'une quelconque des revendications précédentes, dans lequel les première et deuxième branches conduisent de manière simultanée le fluide frigorifique, notamment entre le dispositif RMN de rotation à l'angle magique (150 ; 250) du système RMN et le compresseur (110 ; 210) du système RMN.

8. Procédé de fonctionnement d'un système (100 ; 200 ; 150 ; 250) selon l'une quelconque des revendications 1 à 6 et/ou procédé selon la revendication précédente dans lequel on régule les débits de sorte que les débits de fluide dans les première et troisième branches (161, 261, 181, 281) soient égaux ou sensiblement égaux et/ou dans lequel on régule les débits de fluide de sorte que les débits dans les deuxième et quatrième branches (162, 262, 182, 282) soient égaux ou sensiblement égaux.

## Patentansprüche

1. Fluidleitungssystem (150; 250) für ein NMR-System (100; 200), **dadurch gekennzeichnet, dass** das Leitungssystem (150, 250) Folgendes umfasst:
- einen Auslasskreislauf (160; 260) des NMR-Systems (100; 200), der einen ersten Fluidzirkulationszweig (161; 261) und einen zweiten Fluidzirkulationszweig (162; 262) umfasst, wobei der Auslasskreislauf es ermöglicht, ein Kühlfluid einer NMR-Vorrichtung zur Drehung im magischen Winkel des NMR-Systems (120) zu einem Kompressor (110) des NMR-Systems zu leiten;
- einen Versorgungskreislauf (180; 280) des NMR-Systems, der einen dritten Fluidzirkulationszweig (181; 281) und einen vierten Fluidzirkulationszweig (182; 282) umfasst, wobei der Versorgungskreislauf es ermöglicht, das Kühlfluid vom Kompressor (110) zur NMR-Vorrichtung (120) zu leiten;
- einen ersten Wärmetauscher (E11, E21),
- einen zweiten Wärmetauscher (E12, E22),
- einen dritten Wärmetauscher (E13, E23),
wobei der erste Zweig eine Leitung (1612; 2612) des ersten Wärmetauschers umfasst, der zweite Zweig eine Leitung (2624; 2827) des zweiten Wärmetauschers und eine Leitung (1626; 2626) des dritten Wärmetauschers umfasst, der dritte Zweig eine Leitung (1812; 2812) des ersten Wärmetauschers umfasst und der vierte Zweig eine Leitung (1827; 2827) des zweiten Wärmetauschers und eine Leitung (1823; 2823) des dritten Wärmetauschers umfasst,
wobei der dritte Zweig (181; 281) mehrere Unterzweige umfasst, wobei der dritte Zweig (181; 281) Folgendes umfasst: einen ersten Unterzweig zur Zirkulation eines ersten Stroms, dessen Funktion darin besteht, einen Probenhalter (121, 221) in Drehung zu versetzen, indem er auf die Schaufeln oder Flügel einer Turbine zum Antrieb eines Rotors der NMR-Vorrichtung (120, 220) einwirkt, wobei der Rotor den Probenhalter (121, 221) umfasst, und einen zweiten Unterzweig zur Zirkulation eines dritten Stroms, dessen Funktion darin besteht, ein Schwebelager des Rotors im Stator (122, 222) der NMR-Vorrichtung (120, 220) zu erzeugen, und einen dritten Unterzweig zur Zirkulation eines vierten Stroms, dessen Funktion darin besteht, einen Hitzeschild (140, 240) zu kühlen, der die NMR-Vorrichtung (120, 220) vor thermischer Strahlung schützt, wobei der vierte Zweig (182; 282) einen zweiten Strom leitet, dessen einzige Funktion darin besteht, eine Probe der Vorrichtung auf eine geeignete Temperatur zu bringen.

2. System (150; 250) nach dem vorangehenden Anspruch, **dadurch gekennzeichnet, dass** der erste Zweig (161, 261) keine Leitung eines Kryokühlers umfasst und/oder der zweite Zweig (162, 262) eine Leitung (1622; 2622) eines ersten Kryokühlers (C11; C212) umfasst.

3. System (150; 250) nach einem der vorangehenden Ansprüche, **dadurch gekennzeichnet, dass** der dritte Zweig (181; 281) mindestens eine Leitung (1814; 2814) eines zweiten Kryokühlers (C12; C211) umfasst und/oder dass der vierte Zweig (182, 282) eine Leitung (1825; 2825) eines dritten Kryokühlers (C13; C211) und eine Leitung (1829; 2829) eines vierten Kryokühlers (C14; C212) umfasst.

4. System (150; 250) nach einem der vorangehenden Ansprüche, **dadurch gekennzeichnet, dass** der zweite Zweig (162, 262) einen Durchflussregler (1628; 2628) umfasst.

5. System (150; 250) nach einem der vorangehenden Ansprüche, **dadurch gekennzeichnet, dass** der dritte Zweig (181, 281) mindestens einen Durchflussregler (1811; 2811) umfasst und/oder dass der vierte Zweig (182, 282) einen Durchflussregler (1821; 2821) umfasst.

6. NMR-System (100; 200), umfassend ein Kanalisationssystem (150; 250) nach einem der vorangehenden Ansprüche und eine NMR-Vorrichtung zur Drehung im magischen Winkel (120; 220).

7. Verfahren zum Betreiben eines Systems (100; 200; 150; 250) nach einem der vorangehenden Ansprüche, wobei der erste und der zweite Zweig das Kühlfluid simultan leiten, insbesondere zwischen der NMR-Vorrichtung zur Drehung im magischen Winkel (150; 250) des NMR-Systems und dem Kompressor (110; 210) des NMR-Systems.

8. Verfahren zum Betreiben eines Systems (100; 200; 150; 250) nach einem der Ansprüche 1 bis 6 und/oder Verfahren nach dem vorangehenden Anspruch, wobei die Durchflüsse so geregelt werden, dass die Fluiddurchflüsse durch den ersten und den dritten Zweig (161, 261, 181, 281) gleich oder im Wesentlichen gleich sind, und/oder wobei die Fluiddurchflüsse so geregelt werden, dass die Durchflüsse durch den zweiten und den vierten Zweig (162, 262, 182, 282) gleich oder im Wesentlichen gleich sind.

## Claims

1. Fluid channelling system (150; 250) for NMR system (100; 200), **characterized in that** the channelling system (150, 250) includes:
- an exhaust circuit (160; 260) of the NMR system (100; 200) comprising a first fluid circulation branch (161; 261) and a second fluid circulation branch (162; 262), the exhaust circuit making it possible to convey a coolant fluid from a magic-angle spinning NMR device of the NMR system (120) to a compressor (110) of the NMR system;
- a feed circuit (180; 280) of the NMR system including a third fluid circulation branch (181; 281) and a fourth fluid circulation branch (182; 282), the feed circuit making it possible to convey the coolant fluid from the compressor (110) to the NMR device (120);
- a first heat exchanger (E11, E21),
- a second heat exchanger (E12, E22),
- a third heat exchanger (E13, E23)
the first branch including a pipe (1612; 2612) of the first heat exchanger, the second branch including a pipe (2624; 2827) of the second heat exchanger and a pipe (1626; 2626) of the third heat exchanger, the third branch including a pipe (1812; 2812) of the first heat exchanger and the fourth branch including a pipe (1827; 2827) of the second heat exchanger and a pipe (1823; 2823) of the third heat exchanger,
the third branch (181; 281) including a plurality of sub-branches, the third branch (181; 281) including a first sub-branch for circulation of a first flow the function of which is to rotate a sample-holder (121, 221), by acting on blades or fins of a drive turbine of a rotor of the NMR device (120, 220), the rotor including the sample-holder (121, 221), and a second sub-branch for circulation of a third flow the function of which is to create a bearing supporting the rotor in a stator (122, 222) of the NMR device (120, 220) and a third sub-branch for circulation of a fourth flow the function of which is to cool a heat shield (140, 240) protecting the NMR device (120, 220) from thermal radiation,
the fourth branch (182; 282) conveying a second flow of which the sole function is to bring a sample of the NMR device to an appropriate temperature.

2. System (150; 250) according to the preceding claim, **characterized in that** the first branch (161, 261) includes no cryorefrigerator pipe and/or the second branch (162, 262) includes a pipe (1622; 2622) of a first cryorefrigerator (C11; C212).

3. System (150; 250) according to one of the preceding claims, **characterized in that** the third branch (181; 281) includes at least one pipe (1814; 2814) of a second cryorefrigerator (C12; C211) and/or **in that** the fourth branch (182, 282) includes a pipe (1825; 2825) of a third cryorefrigerator (C13; C211) and a pipe (1829; 2829) of a fourth cryorefrigerator (C14; C212).

4. System (150; 250) according to one of the preceding claims, **characterized in that** the second branch (162, 262) includes a flow rate regulator (1628; 2628).

5. System (150; 250) according to one of the preceding claims, **characterized in that** the third branch (181, 281) includes at least one flow rate regulator (1811; 2811) and/or **in that** the fourth branch (182, 282) includes a flow rate regulator (1821; 2821).

6. NMR system (100; 200) including a channelling system (150; 250) according to any one of the preceding claims and a magic-angle spinning NMR device (120; 220).

7. Method for operating a system (100; 200; 150; 250) according to any one of the preceding claims, in which the first and second branches convey the coolant fluid simultaneously, in particular between the magic-angle spinning NMR device (150; 250) of the NMR system and the compressor (110; 210) of the NMR system.

8. Method for operating a system (100; 200; 150; 250) according to any one of Claims 1 to 6 and/or method according to the preceding claim, in which the flow rates are regulated so that the fluid flow rates in the first and third branches (161, 261, 181, 281) are equal or substantially equal and/or in which the fluid flow rates are regulated so that the flow rates in the second and fourth branches (162, 262, 182, 282) are equal or substantially equal.
